## Europäisches Patentamt
## European Patent Office
## Office européen des brevets

(19)

(11) Publication number: **0 128 675**
**B1**

(12) **EUROPEAN PATENT SPECIFICATION**

(45) Date of publication of patent specification: **29.07.87**

(51) Int. Cl.⁴: **H 01 L 21/90**

(21) Application number: **84303298.8**

(22) Date of filing: **16.05.84**

(54) A method of fabricating an integrated circuit having multi-layer wiring with a fuse and a fuse opening.

(30) Priority: **16.05.83 JP 85302/83**

(43) Date of publication of application:
**19.12.84 Bulletin 84/51**

(45) Publication of the grant of the patent:
**29.07.87 Bulletin 87/31**

(84) Designated Contracting States:
**DE FR GB**

(56) References cited:
**EP-A-0 025 347**

**IBM TECHNICAL DISCLOSURE BULLETIN, vol.
23, no. 10, March 1981, New York, USA; D.E.
DAVIS et al. "Passivation process for
semiconductor device with fusible link
redundancy", pages 4451-4452**

(73) Proprietor: **FUJITSU LIMITED**
**1015, Kamikodanaka Nakahara-ku
Kawasaki-shi Kanagawa 211 (JP)**

(72) Inventor: **Takayama, Yoshihisa c/o FUJITSU
LIMITED**
**Patent Department 1015 Kamikodanaka
Nakahara-ku
Kawasaki-shi Kanagawa 211 (JP)**
Inventor: **Gotoh, Kunihiko c/o FUJITSU
LIMITED**
**Patent Department 1015 Kamikodanaka
Nakahara-ku
Kawasaki-shi Kanagawa 211 (JP)**
Inventor: **Ito, Akihiko c/o FUJITSU LIMITED**
**Patent Department 1015 Kamikodanaka
Nakahara-ku
Kawasaki-shi Kanagawa 211 (JP)**
Inventor: **Yamamura, Takeshi c/o FUJITSU
LIMITED**
**Patent Department 1015 Kamikodanaka
Nakahara-ku
Kawasaki-shi Kanagawa 211 (JP)**
Inventor: **Fujita, Kazuyoshi c/o FUJITSU
LIMITED**
**Patent Department 1015 Kamikodanaka
Nakahara-ku
Kawasaki-shi Kanagawa 211 (JP)**

Courier Press, Leamington Spa, England.

**0 128 675**

(74) Representative: **Sunderland, James Harry et al
HASELTINE LAKE & CO Hazlitt House
28 Southampton Buildings Chancery Lane
London WC2A 1AT (GB)**

## Description

The present invention is concerned with integrated circuits (IC's) having multi-layer wiring, and which are programmable by blowing fuses provided in the IC's so as to select specific circuits, such as redundant circuits, in the IC's, to meet specific requirements placed on the IC's.

The present invention relates to a method of fabricating an integrated circuit having multi-layer wiring with a fuse and a fuse opening for releasing heat generated, and for dispersing material and gas generated, when the fuse is blown.

Recently, there has been increasing use of fuses such as polycrystalline silicon (polysilicon) fuses for permanently programmable circuit elements. For example, they are used for selecting redundant circuit blocks in MOS memories. As another example, they are used to obtain an accurate reference voltage source for a D/A converter, a coder/decoder (CODEC), and so on, where a reference voltage is adjusted by trimming circuits with fuses arranged in the circuits. In those cases, the fuses are selectively blown off by electrical or laser power according to the programming method employed.

At present, polysilicon fuses are generally used because of the relatively high resistivity of polysilicon in comparison with other materials and its availability in IC fabricating processes. Such fuses are usually blown by applying high electrical currents in accordance with predetermined programming data.

Polysilicon fuses are generally arranged on a silicon substrate and formed together with other polysilicon conducting paths for wiring the circuit concerned. They are formed in the same layer (structure) as other electronic components such as transistors, diodes, resistors, capacitors and the like. The fuses are sandwiched between a substrate and insulating layers made of silicon dioxide ($SiO_2$), phospho-silicate glass (PSG) and so on, formed over the circuit layer (structure) to protect the circuit.

Usually a fuse is created by narrowing locally the width of a polysilicon conducting path at the point where the fuse is to be positioned, so that the fuse has higher resistivity than remaining portions of the conducting path. By passing a specified electric current, the fuse (polysilicon resistor) is heated to a temperature high enough to melt, and is blown. The heat generated by the melting of the fuse is conducted to the neighbouring parts of the circuit, heating them up and possibly causing undesirable effects. For example, the dopant concentration of a semiconductor junction may be changed, so damaging it. In addition, melted fuse material and a considerable volume of gas released during the fuse blowing, may burst out damaging thermally and mechanically the layers in the vicinity of the fuse. This may lead to the disconnection or electrical shorting of wiring, or other damage. In addition, the blowing of the fuse itself is often not satisfactory and the circuitry of interest is not disconnected completely as it should be by blowing of the fuse.

In order to eliminate these drawbacks, generally, an opening is formed in the insulating layers covering the fuse, to expose the fuse to the outside environment so as to dissipate the heat conducted from the blown fuse and to release and disperse melted material and gas. This is an effective countermeasure but is accompanied by another problem, as follows.

As the demand for higher integration increases, a multi-layer wiring structure is increasingly employed in IC's. The multi-layer wiring system can provide not only higher integration but also greater freedom of design of IC's. In multi-layer circuits, a wiring layer must be covered by an insulating layer, and so several layers, with wiring layers alternating with insulating layers, are formed on top of each other until the necessary number of wiring layers is completed. As a result, a fuse may be covered by more than two insulating layers, and a fuse opening must be formed by removing portions of all the insulating layers covering the fuse of interest. The removal of the insulating layers is performed by a conventional selective etching method, which is basically a chemical and physical process difficult to control to precise dimensions. This fact, together with the large thickness (more than several μm) of the insulating layers to be etched as described above, makes it difficult to form an opening.

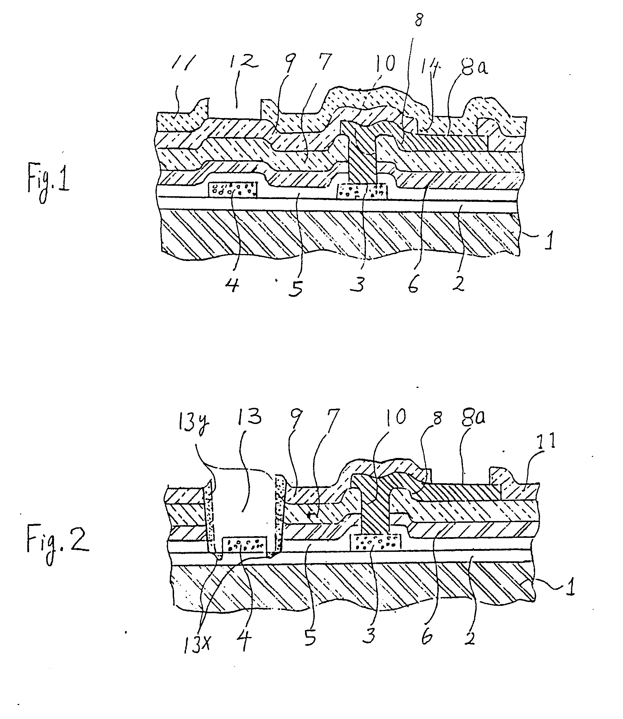

As an example, an IC device with two-layer wiring fabricated according to a previous method will be described briefly. Schematic cross-sectional elevation views are illustrated in Fig. 1 and Fig. 2, showing the structure in the vicinity of a fuse respectively before and after an etching operation for forming an opening.

Briefly, the structure shown in Fig. 1 is fabricated as follows. A silicon substrate 1 is covered by a silicon dioxide ($SiO_2$) layer 2 on which a wiring layer 3 including a polysilicon resistor fuse 4 is formed. This is covered by a silicon dioxide ($SiO_2$) layer 5 and a silicon nitride ($Si_3N_4$) layer 6, over which a phosphosilicate glass (PSG) layer 7 is formed. The second wiring layer 8 (whose conducting paths are formed of aluminium) formed on the first PSG layer 7 is connected through a contact hole 10 opened in the layers 5, 6 and 7 by an etching method. Finally, a PSG layer 9 is formed over the second wiring layer 8 as a passivation layer A window 14 for a bonding pad 8a is then opened by etching with the aid of a photolithographic technology in the PSG layer 9, over which a photoresist film 11 is formed. A window 12 is opened in this film 11 right above the fuse 4. Now the device is as shown in Fig. 1, and is ready for fabricating an opening.

As can be clearly seen from Fig. 1, in order to form an opening 13 on the fuse 4 to expose it to the air, it is necessary to etch through the whole thickness of layers 9, 7, 6 and 5. In such a case, the etching operation is done by a combination of chemical (wet) and physical (dry) etching operations, but a long etching time is necessary for this purpose, resulting in problems such as unavoidable overetching and underetching (for example, as shown by dotted areas 13x and 13y respectively in Fig. 2). As a result, in the case of a multi-layered IC, it is very difficult to provide an opening of accurately determined dimensions and to avoid overetching into regions (of the wiring layer, for example) which should not be etched. This decreases the fabricating yield of the IC device.

According to the present invention there is provided a method of fabricating an integrated circuit device having multi-layer wiring with a fuse and an opening for the fuse in its layer structure, including the steps of:

(a) forming a first wiring layer including the fuse;

(b) forming a first insulating layer, composed of a plurality of insulating component layers laminated one over another, including at least an uppermost component layer and a lowest component layer, covering the first wiring layer and the fuse;

(c) removing at least the uppermost component layer of the first insulating layer, without removing the lowest component layer, in a region over the fuse, for the opening for the fuse;

(d) forming a further wiring layer, above the first insulating layer;

(e) forming a further insulating layer, covering the further wiring layer; and

(f) removing the further insulating layer in a region over the fuse, for the opening for the fuse, thereby leaving only one or more component layers of the first insulating layer, of a small thickness, covering the fuse, so as to allow the fuse to be subsequently blown without damaging the integrated circuit device.

A method embodying the present invention can offer higher fabrication yield, without increasing cost, for IC's with multi-layer wiring and fuses.

A method embodying the present invention can provide for the formation of fuse openings with higher dimensional accuracy than the previous method mentioned above.

In a method embodying the present invention, formation of an insulating layer over a wiring layer is followed by removal of a portion of the insulating layer in a region over a fuse before formation of a next wiring layer.

An insulating layer covering a wiring layer or separating two wiring layers may comprise a plurality of component layers each of insulating material.

In embodiments of the present invention only a part of the thickness of an insulating layer on a fuse is removed before formation of a next wiring layer. That is, only an uppermost component layer or layers are removed. The remainder of the thickness of that insulating layer may be removed after formation of all wiring layers, or may be left in place until the fuse is blown.

Removal of portions of insulating layers is effected by a conventional wet or dry or combined etching method, but etching depth is limited at each removal to at most the thickness of one insulating layer, so each etching process is finished in a relatively short time. This also eliminates the problem of imprecise dimensions of a fuse opening, for example, over etching layer parts neighbouring the fuse opening, and results in an increase of the fabricating yield.

The etching for removal of a portion of an insulating layer in a region over a fuse, for forming the fuse opening, can be an etching employed also for removing a portion of the insulating layer in a region over a connection portion of the wiring layer covered by the insulating layer, thereby achieving two removals simultaneously. For example the etching may be that used for forming a contact hole in the insulating layer or for forming an opening for a bonding pad.

Therefore, additional process steps need not be required and the cost need not be greater than that of the previous method mentioned above.

A wiring layer with a fuse may be the lowest, i.e. earliest to be formed, wiring layer of an IC, or may not be that lowest layer.

Reference is made, by way of example, to the accompanying drawings, in which:

Fig. 1 is a schematic cross-sectional view of an IC device with two-layer wiring, just before formation of an opening for a fuse by an etching operation, according to a previous fabrication method:

Fig. 2 is a schematic cross-sectional view of the device of Fig. 1, after completion of the etching operation for forming the opening for the fuse;

Figs. 3 to 7, 8b, 9 and 10 are schematic cross-sectional views illustrating steps in a method of fabricating an IC device with two-layer wiring in accordance with an embodiment of the present invention; and

Fig. 8(a) is a plan view corresponding to Fig. 8(b), in which the section is taken along the line X—X in Fig. 8(a):—

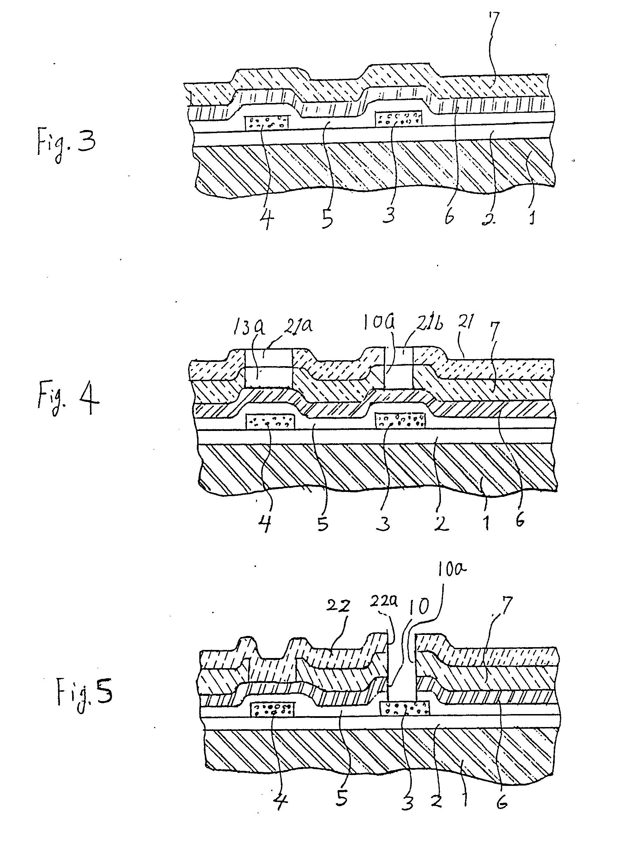

Fig. 3 shows the device after completion of a first PSG layer over a silicon nitride (Si$_3$N$_4$) layer,

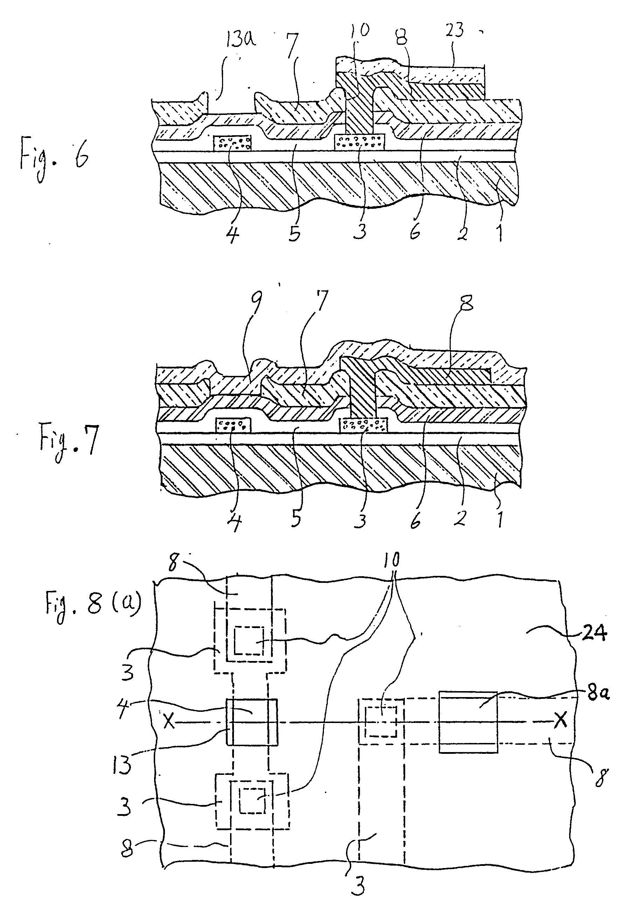

Fig. 4 shows the device after preliminary etching for a fuse opening and a contact hole in the first PSG layer,

Fig. 5 shows the device with the contact hole completed,

Fig. 6 shows the device ready for patterning of a second wiring layer,

Fig. 7 shows the device with a second PSG layer formed over the second wiring layer,

Figs. 8(a) and 8(b) show the device with the second PSG layer etched to provide a bonding pad and a half formed opening in the layer,

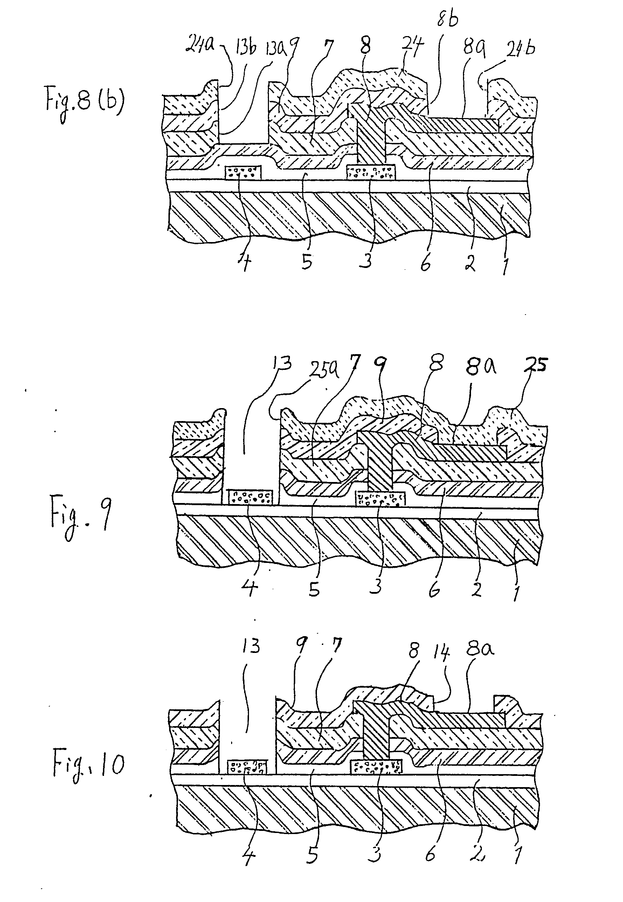

Fig. 9 shows the device covered by a photoresist film layer having a window above a fuse and ready for a final etching process to complete the fuse opening, and

Fig. 10 shows the device after completion of the fuse opening.

An embodiment of the present invention offers an improved way of fabricating openings for fuses in an IC with multi-layer wiring. The above mentioned drawbacks of the previous fabricating method are overcome by forming an opening for a fuse in a series of steps; that is, etching of fuse opening is partially performed each time an insulating layer or passivation layer is formed over a wiring layer. In these etching steps, the necessary contact holes or openings for bonding pads, are also formed to save fabrication time and cost.

In the method of Figs. 3 to 10, elementary processing methods used such as etching, insulating layer formation, aluminium sputtering, lithographic technology etc. are conventional and well known among those skilled in the art, so detailed description of these is omitted in the following disclosure.

As shown in Fig. 3, a silicon dioxide ($SiO_2$) layer 2, a first wiring layer 3 including a fuse 4, a second silicon dioxide layer ($SiO_2$) layer 5, a silicon nitride ($Si_3N_4$) layer 6 and a first PSG layer 7 are formed one above another on a silicon substrate 1 as in a conventional process for fabricating an IC. Subsequently however, the fabricating processes employed in the illustrated embodiment of the present invention differ from the conventional.

Step a: With a lithographic technology, a photoresist film layer 21 is formed covering the PSG layer 7 and having an opened hole or window 21a for forming an opening 13a for the fuse 4 and a hole 21b for forming a contact hole 10a as shown in Fig. 4. This is followed by a conventional isotropic wet etching process using a solution such as a mixture of hydrofluoric (hydrofluoride) acid and others. Of course, a dry etching method such as reactive ion plasma etching (RIPE), or a chemical dry etching (CDE) method or the like could be applied. These isotropic or anisotropic etching processes should be selected according to the required dimensional accuracy, the kind of material to be etched and the ease of application. The etching results in exposure of the silicon nitride ($Si_3N_4$) layer 6 at the bottom of two etched holes 10a and 13a. After that, the photoresist film 21 is removed.

Step b: As shown in Fig. 5, the PSG layer 7 is covered again by a photoresist film layer 22 and a window 22a is opened, by a lithographic method, only over the contact hole 10a, being followed by an etching process to extend the contact hole 10a to reach the first wiring layer 3 to complete a contact hole 10 for a connection portion of the first wiring layer 3. The fuse 4 is still protected by the layers 5 and 6.

Step c: Removal of the residual photoresist film 22, is followed by an aluminium sputtering process over the PSG layer 7. The sputtering process fills up the contact hole 10 with aluminium, connecting the wiring layer to the sputtered aluminium layer from which a second wiring layer 8 is to be patterned. The sputtered aluminium layer is etched selectively with the aid of a patterned photoresist film layer 23 to form the second wiring layer 8 as shown in Fig. 6.

Step d: Following the completion of the second wiring layer, a second PSG layer 9 is formed over the second wiring layer 8, by a chemical vapour deposition (CVD) method to avoid damage to the aluminium layer due to heating. This state is shown in Fig. 7.

Step e: A photoresist film layer 24 having a window 24a in the region over the fuse 4 and a window 24b for a connection portion, a bonding pad 8a is formed over the second PSG layer 9, whose exposed portions are removed by etching to form a partial opening 13b and a hole (window) 8b for the bonding pad 8a, exposing the surface of wiring layer 8. This is illustrated in Fig. 8(a) in a plan view and Fig. 8(b) in a cross-sectional view.

Step f: After the above-mentioned process, the surface of the PSG layer 9 is covered with a photoresist film layer 25 except for the region of the partial opening 13a. The aluminium layer of the bonding pad is protected by the photoresist film 25 against the subsequent etching, by which the portions of the silicon nitride ($Si_3N_4$) layer 6 and silicon dioxide ($SiO_2$) layer 5 covering the fuse 4, are etched and removed to complete the opening 13 to expose the fuse 4 as shown in Fig. 9.

By removing the photoresist film layer 25, the fabricating process for the opening for the fuse is finished as shown in Fig. 10.

Considering the phenomena accompanying the blowing of a fuse, it will be understood that complete exposure of the fuse to the environment is not always necessary, and in fact thin layers may be allowed to remain on the fuse to protect the fuse against environmental hazards. For example, thin layers such as the silicon nitride layer 6 and silicon oxide layer 5 can be left on the surface of the fuse 4 as shown in Fig. 8(b), eliminating one fabricating process, step f, and hence reducing cost.

The above description of an embodiment of the present invention has been given in connection with an IC with two-layer wiring, but it will be clear to those skilled in the art that embodiments of the present invention can be applicable to IC devices having more than two wiring layers by repeating some of the processes disclosed above, for example steps c, d and e.

**Claims**

1. A method of fabricating an integrated circuit device having multi-layer wiring with a fuse (4) and an opening for the fuse in its layer structure, including the steps of:

(a) forming a first wiring layer (3) including the fuse (4);

(b) forming a first insulating layer composed of a plurality of insulating component layers (5, 6, 7) laminated one over another, including at least an uppermost component layer (7) and a lowest component layer (5), covering the first wiring layer (3) and the fuse (4);

(c) removing at least the uppermost component layer (7) of the first insulating layer (5, 6, 7) without removing the lowest component layer (5), in a region over the fuse (4), for the opening for the fuse;

(d) forming a further wiring layer (8), above the first insulating layer;

(e) forming a further insulating layer (9), covering the further wiring layer (8); and

(f) removing the further insulating layer (9) in a region over the fuse (4), for the opening for the fuse,

thereby leaving only one or more component layers of the first insulating layer, of a small thickness, covering the fuse, so as to allow the fuse to be subsequently blown without damaging the integrated circuit device.

2. A method according to claim 1, further comprising, at step (c), simultaneously removing at least the uppermost component layer (7) of the first insulating layer, without removing the lowest component layer (5), in a region over a connection portion of the first wiring layer (3), to which portion a connection is to be established.

3. A method according to claim 2, further comprising, following step (c), subsequently removing the or each remaining component layer (5, 6) of the first insulating layer in the region over the connection portion.

4. A method according to claim 1, 2, or 3, further comprising, at step (f), simultaneously removing the further insulating layer (9) in a region over a connection portion of the further wiring layer (8), to which portion a connection is to be established.

5. A method according to claim 2, 3 or 4, wherein the removal in the region over the connection portion forms a contact hole (10).

6. A method according to claim 2, 3 or 4, wherein the connection portion is a bonding pad (8a).

7. A method according to any preceding claim, wherein steps (d), (e), and (f) are repeated to form a plurality of further wiring layers and further insulating layers above one another.

8. A method according to any preceding claim, wherein the said first wiring layer (3) is the lowest wiring layer of the device.

9. A method according to any one of claims 1 to 7, wherein the said first wiring layer (3) is not the lowest wiring layer.

10. A method according to any preceding claim, wherein the or each or a further insulating layer (9) is composed of a plurality of component layers each of insulating material.

11. A method according to any preceding claim, comprising the further step of:

(g) removing the or each remaining component layer (5, 6) of the first insulating layer in the region over the fuse (4).

12. A method according to any one of claims 1 to 10, wherein the lowest component layer (5) of the first insulating layer, and any further remaining component layer of the first insulating layer, in the region over the fuse (4) is left in place.

13. A method according to any preceding claim, wherein layers of silicon dioxide and/or silicon nitride are provided as insulating component layers of the first insulating layer or of the or each or a further insulating layer.

14. A method according to any preceding claim, wherein the first and/or the or each or a further insulating layer includes phosphosilicate glass.

15. A method according to any preceding claim, wherein the fuse (4) is of polycrystalline silicon.

**Patentansprüche**

1. Verfahren zur Herstellung einer integrierten Schaltungsvorrichtung mit einer mehrschichtigen Verdrahtung, mit einer Sicherung (4) und einer Öffnung für die Sicherung in ihrer Schichtstruktur, mit den folgenden Schritten:

(a) Bildung einer ersten Verdrahtungsschicht (3), welche die Sicherung (4) enthält;

(b) Bildung einer ersten isolierenden Schicht, die aus einer Vielzahl von isolierenden Komponentenschichten (5, 6, 7) besteht, die eine über der anderen laminiert sind, einschließlich wenigstens einer obersten Komponentenschicht (7) und einer untersten Komponentenschicht (5), welche die erste Verdrahtungsschicht (3) und die Sicherung (4) bedeckt;

(c) Entfernung von wenigstens der obersten Komponentenschicht (7) der ersten isolierenden Schicht (5, 6, 7), ohne Entfernen der untersten Komponentenschicht (5), in einem Bereich über der Sicherung (4), für die Öffnung für die Sicherung;

(d) Bildung einer weiteren Verdrahtungsschicht (8), oberhalb der ersten isolierenden Schicht;

(e) Bildung einer weiteren isolierenden Schicht (9), welche die weitere Verdrahtungsschicht (8) bedeckt; und

(f) Entfernen der weiteren isolierenden Schicht (9) in einem Bereich über der Sicherung (4), für die Öffnung für die Sicherung,

wodurch lediglich eine oder mehrere Komponentenschichten der ersten isolierenden Schicht übriggelassen werden, von einer geringen Dicke, welche die Sicherung bedecken, um so zu erlauben, daß die Sicherung nachträglich durchgebrannt wird, ohne die integrierte Schaltungsvorrichtung zu beschädigen.

2. Verfahren nach Anspruch 1, ferner mit gleichzeitiger Entfernung von wenigstens der obersten Komponentenschicht (7) der ersten isolierenden Schicht, bei dem Schritt (c), ohne die unterste Komponentenschicht (5) zu entfernen, in einem Bereich über einem Verbindungsabschnitt der ersten Verdrahtungsschicht (3), zu welchem Abschnitt eine Verbindung hergestellt werden soll.

3. Verfahren nach Anspruch 2, ferner mit, nach dem Schritt (c) folgender, Entfernung der oder jeder verbleibenden Komponentenschicht (5, 6) der ersten isolierenden Schicht in dem Bereich über dem Verbindungsabschnitt.

4. Verfahren nach Anspruch 1, 2 oder 3, ferner mit, bei dem Schritt (f), gleichzeitiger Entfernung der weiteren isolierenden Schicht (9) in einem Bereich über einem Verbindungsabschnitt der weiteren Verdrahtungsschicht (8), zu welchem Abschnitt eine Verbindung hergestellt werden soll.

5. Verfahren nach Anspruch 2, 3 oder 4, bei dem die Entfernung in dem Bereich über dem Verbindungsabschnitt ein Kontaktloch (10) bildet.

6. Verfahren nach Anspruch 2, 3 oder 4, bei dem der Verbindungsabschnitt ein Bonding-Pad (8a) ist.

7. Verfahren nach einem der vorhergehenden Ansprüche, bei dem die Schritte (d), (e) und (f) wiederholt werden, um eine Vielzahl von weiteren Verdrahtungsschichten und weiteren Isolationsschichten, eine über der anderen, zu bilden.

8. Verfahren nach einem der vorhergehenden Ansprüche, bei dem die genannte erste Verdrahtungsschicht (3) die unterste Verdrahtungsschicht der Vorrichtung ist.

9. Verfahren nach einem der Ansprüche 1 bis 7, bei dem die genannte erste Verdrahtungsschicht (3) nicht die unterste Verdrahtungsschicht ist.

10. Verfahren nach einem der vorhergehenden Ansprüche, bei dem die oder jede weitere Isolationsschicht (9) aus einer Vielzahl von Komponentenschichten, jeweils aus isolierendem Material, besteht.

11. Verfahren nach einem der vorhergehenden Ansprüche, ferner mit dem Schritt der:

(g) Entfernung der oder jeder verbleibenden Komponentenschicht (5, 6) der ersten isolierenden Schicht in dem Bereich über der Sicherung (4).

12. Verfahren nach einem der Ansprüche 1 bis 10, bei dem die unterste Komponentenschicht (5) der ersten isolierenden Schicht, und irgendeine weitere verbleibende Komponentenschicht der ersten isolierenden Schicht, in dem Bereich über der Sicherung (4) an ihrem Platz gelassen wird.

13. Verfahren nach einem der vorhergehenden Ansprüche, bei dem Schichten aus Siliziumdioxid und/oder Siliziumnitride als isolierende Komponentenschichten der ersten isolierenden Schicht oder der oder jeder oder einer weiteren isolierenden Schicht vorgesehen sind.

14. Verfahren nach einem der vorhergehenden Ansprüche, bei dem die erste und/oder die oder jede oder eine weitere isolierende Schicht Phosphorsilikat glas enthält.

15. Verfahren nach einem der vorhergehenden Ansprüche, bei dem die Sicherung (4) aus polykristallinem Silizium besteht.

## Revendications

1. Procédé de fabrication d'un circuit intégré ayant un câblage multicouche muni d'un fusible (4) et une ouverture pour le fusible, dans sa structure en couches, comprenant les étapes suivantes:

(a) la formation d'une première couche (3) de câblage comprenant le fusible (4),

(b) la formation d'une première couche isolante composée de plusieurs couches isolantes élémentaires (5, 6, 7) associées les unes sur les autres, comprenant au moins une couche élémentaire supérieure (7) et une couche élémentaire inférieure (5), recouvrant la première couche de câblage (3) et le fusible (4),

(c) l'enlèvement de la couche élémentaire supérieure (7) au moins de la première couche isolante (5, 6, 7) sans enlèvement de la couche élémentaire inférieure (5), dans une région recouvrant le fusible (4), en vue de la formation de l'ouverture du fusible,

(d) la formation d'une couche supplémentaire de câblage (8) au-dessus de la première couche isolante,

(e) la formation d'une couche isolante supplémentaire (9), recouvrant la couche supplémentaire de câblage (8), et

(f) l'enlèvement de la couche isolante supplémentaire (9) dans une région recouvrant le fusible (4) afin que l'ouverture du fusible soit formée,

si bien qu'il ne reste qu'une ou plusieurs couches élémentaires de la première couche isolante, avec une faible épaisseur, au-dessus du fusible, et que le fusible peut ensuite être grillé sans détérioration du circuit intégré.

2. Procédé selon la revendication 1, comprenant en outre, dans l'étape (c), l'enlèvement simultané de la couche élémentaire supérieure (7) au moins de la première couche isolante, sans enlèvement de la couche élémentaire inférieure (5), dans une région recouvrant une partie de connexion de la première couche de câblage (3), partie dans laquelle une connexion doit être établie.

3. Procédé selon la revendication 2, comprenant en outre, après l'étape (c), l'enlèvement ultérieur de la couche élémentaire restante ou de chaque couche élémentaire restante (5, 6) de la première couche isolante dans la région recouvrant la partie de connexion.

4. Procédé selon l'une quelconque des revendications 1, 2 et 3, comprenant en outre, dans l'étape (f), l'enlèvement simultané de la couche isolante supplémentaire (9) dans une région recouvrant une partie de connexion de la couche supplémentaire de câblage (8), partie dans laquelle une connexion doit être établie.

5. Procédé selon l'une quelconque des revendications 2, 3 et 4, dans laquelle l'enlèvement, réalisé dans la région qui recouvre la partie de connexion, forme un trou de contact (10).

6. Procédé selon l'une quelconque des revendications 2, 3 et 4, dans lequel la partie de connexion est une plage de liaison (8a).

7. Procédé selon l'une quelconque des revendications précédentes, dans laquelle les étapes (d) (e) et (f) sont répétées afin que plusieurs couches supplémentaires de câblage et plusieurs couches isolantes soient formées les unes sur les autres.

8. Procédé selon l'une quelconque des revendications précédentes, dans lequel la première couche de câblage (3) est la couche de câblage la plus basse du dispositif.

9. Procédé selon l'une quelconque des revendications 1 à 7, dans lequel la première couche de câblage (3) n'est pas la couche de câblage la plus basse.

10. Procédé selon l'une quelconque des revendications précédentes, dans lequel la couche isolante supplémentaire ou chaque couche isolante supplémentaire (9) est composée de plusieurs couches élémentaires formées chacune d'un matériau isolant.

11. Procédé selon l'une quelconque des revendications précédentes, comprenant l'étape supplémentaire suivante:

(g) l'enlèvement de la couche élémentaire restante ou de chaque couche élémentaire restante (5, 6) de la première couche isolante dans la région se trouvant au-dessus du fusible (4).

12. Procédé selon l'une quelconque des revendications 1 à 10, dans lequel la couche élémentaire la plus basse (5) de la première couche isolante, et toute couche élémentaire restante supplémentaire de la première couche isolante, dans la région recouvrant le fusible (4), est laissée en place.

13. Procédé selon l'une quelconque des revendications précédentes, dans lequel des couches de bioxyde de silicium et/ou de nitrure de silicium sont disposées comme couche élémentaires isolantes de la première couche isolante et de la couche isolante supplémentaire ou de chaque couche isolante supplémentaire ou d'une couche isolante supplémentaire.

14. Procédé selon l'une quelconque des revendications précédentes, dans lequel la première couche isolante supplémentaire et/ou la couche isolante supplémentaire, chaque couche isolante supplémentaire ou une couche isolante supplémentaire contient un verre de phospho-silicate.

15. Procédé selon l'une quelconque des revendications précédentes, dans lequel le fusible (4) est formé de silicium polycristallin.

Fig.1

Fig.2

Fig. 3

Fig. 4

Fig. 5

Fig. 6

Fig. 7

Fig. 8 (a)

Fig. 8 (b)

Fig. 9

Fig. 10